# EUROPEAN PATENT APPLICATION

(11) **EP 1 772 495 A2**
(43) Date of publication of application: **11.04.2007**
(21) Application number: 06254927.4
(22) Date of filing: 25.09.2006
(51) Int. Cl.: C09D 9/00, C11D 11/00, H01L 21/306, C09K 13/08, C11D 7/00

(54) **Stripper**

(30) Priority: 30.09.2005 US 722760 P
(71) Applicant: Rohm and Haas Electronic Materials LLC, Marlborough, MA 01752 (US)
(72) Inventor: Auger, Robert, Hopedale, MA 01747 (US)
(74) Representative: Kent, Venetia Katherine

(57) **Abstract**

Compositions and methods useful for the removal of polymeric material and copper oxide from substrates, such as electronic devices are provided. These compositions and methods are particularly suitable for removing polymer residues from electronic devices following plasma etch processes.

## Description

The present invention relates generally to the field of removal of polymeric materials from a substrate. In particular, the present invention relates to compositions and methods for the removal of post etch residue from electronic devices.

Numerous materials containing polymers are used in the manufacture of electronic devices, such as photoresists, solder masks, antireflective coatings, and under layers. For example, a positive-type photoresist is deposited on a substrate. The resist is exposed to patterned actinic radiation. The exposed regions are subject to a dissolution by a suitable developer liquid. After the pattern has been thus defined in the resist, it is transferred to the substrate, such as by plasma etching. During the etching step, a plasma etch residue can be formed along the walls of the etched features and along the side walls of the resist features. Following the etching step, the resist and the etch residue are typically completely removed from the substrate to avoid adversely affecting or hindering subsequent operations or processing steps. Even the partial remains of a resist in an area to be further patterned is undesirable. Also, undesired residue between patterned features can have deleterious effects on subsequent film depositions processes, such as metallization, or cause undesirable surface states and charges leading to reduced device performance.

During the etching step, such as plasma etching, reactive ion etching or ion milling, the resist is subjected to conditions that make its removal difficult. During the plasma etch process, fluorocarbon in the plasma gas forms a hard to remove polymeric residue on the sidewalls of the various features being etched, as well as on the resist pattern itself. The polymeric residue, which may include organometallic polymer residue, is extensively cross-linked due to the high vacuum and high temperature conditions in the etch chamber, and typically contains a metal. Known cleaning processes do not acceptably remove such polymeric residue.

Fluoride-based removers are conventionally used to remove such post plasma etching residue. U.S. Patent No. 6,896,826 (Wojtczak et al.) discloses a composition including a fluoride source, organic amine, a nitrogen-containing carboxylic acid and water. The nitrogen-containing carboxylic acids in this patent attach to the copper surface and form a protective layer that prevents the copper surface from being corroded by other components in the composition.

There are integrated circuit manufacturing processes in which a certain amount of copper removal is required, such as in the removal of copper oxides from a copper surface. While conventional fluoride-based removers are effective in removing a variety of polymeric reside, such removers are not effective in the controlled removal of copper without causing excessive etching of the copper, may cause excessive etching of a dielectric layer on the substrate, may operate at a temperature that is outside the desired process window for the manufacturing process, may not have a long enough bath life to allow sufficient processing time and/or throughput for a cost effective process, or may not be effective at removing all types of post plasma etching residue.

There is a continuing need for removers, particularly post plasma etch polymer removers, that effectively remove polymeric material from a substrate and that provide controlled removal of copper and particularly copper oxides.

The present invention provides a composition for the removal of polymeric material from a substrate including: (a) 0.05 to 5 %wt of a fluoride source; (b) 40 to 95 %wt of organic solvent; (c) 5 to 50 %wt water; and (d) a nitrogen-containing carboxylic acid that is soluble in alcohol and has a water solubility of ≥ 25 g per 100 g water at 25 °C. In one embodiment, the organic solvent is a mixture of a polyhydric alcohol and an ether. Such composition typically has a pH of 3 to 8. In another embodiment, the pH is from 4 to 7.

Further, the present invention provides a method of removing polymeric residue from a substrate including the step of contacting a substrate including polymeric residue with the composition described above for a period of time sufficient to remove the polymeric residue.

As used throughout the specification, the following abbreviations shall have the following meanings: nm = nanometers; g = grams; g/L = grams per liter; µm = micron = micrometer; ppm = parts per million; °C = degrees Centigrade; %wt = weight percent; Å = Angstroms; cm = centimeters; min = minute; AF = ammonium fluoride; ABF = ammonium bifluoride; TMAF = tetramethylammonium fluoride; IZ = imidazole; TEOA = triethanolamine; DPM = dipropylene glycol monomethyl ether; PGP = propylene glycol n-propyl ether; PGM = propylene glycol monomethyl ether; MPD = 2-methyl-1,3-propanediol; PDO = 1,3-propanediol; PG = propylene glycol; EG = ethylene glycol; DAP = 1,3-diaminopropane; and DBU = 1,8-diazabicyclo[5.4.0]undec-7-ene.

The terms "stripping" and "removing" are used interchangeably throughout this specification. Likewise, the terms "stripper" and "remover" are used interchangeably. "Alkyl" refers to linear, branched and cyclic alkyl. The term "substituted alkyl" refers to an alkyl group having one or more of its hydrogens replaced with another substituent group, such as halogen, cyano, nitro, (C₁-C₆)alkoxy, mercapto, (C₁-C₆)alkylthio, and the like. The term "moiety" refers to a part of a compound.

The indefinite articles "a" and "an" are intended to include both the singular and the plural. All ranges are inclusive and combinable in any order except where it is clear that such numerical ranges are constrained to add up to 100%.

The compositions useful in the present invention include (a) 0.05 to 5 %wt of a fluoride source; (b) 40 to 95 %wt of organic solvent; (c) 5 to 50 %wt water; and (d) a nitrogen-containing carboxylic acid that is soluble in alcohol and has a water solubility of ≥ 25 g per 100 g water at 25 °C.

A wide variety of fluoride sources may be used in the present invention. In one embodiment, the fluoride source has the general formula R¹R²R³R⁴N⁺ F , wherein R¹, R², R³ and R⁴ are independently chosen from hydrogen, (C₁-C₁₀)alkyl, and substituted (C₁-C₁₀)alkyl. Other suitable fluoride sources include ammonium bifluoride, ammonium-tetraalkylammonium bifluoride, ammonium borofluoride, and fluoroboric acid. It will be appreciated by those skilled in the art that a mixture of fluoride sources may be used, such as a mixture of ammonium fluoride and ammonium bifluoride. In one embodiment, the fluoride source is chosen from ammonium fluoride, ammonium bifluoride, tetraalkylammonium fluoride, ammonium-tetraalkylammonium bifluoride, and mixtures thereof. Exemplary tetraalkylammonium fluoride compounds include, without limitation, tetramethylammonium fluoride and tetrabutylammonium fluoride. In a particular embodiment, the fluoride source is chosen from ammonium fluoride, ammonium bifluoride and mixtures thereof.

The fluoride source is typically present in the compositions of the present invention in an amount of from 0.05 to 5 %wt based on the total weight of the composition, preferably from 0.1 to 5 %wt, and more preferably from 0.5 to 3.5 %wt. Those skilled in the art will appreciate that higher levels of fluoride source may be used in the present compositions, such as up to 10 %wt, or even greater. Fluoride sources are generally commercially available and may be used without further purification.

A wide variety of organic solvents may be used in the present compositions. Such organic solvents are water miscible, stable to hydrolysis and do not destabilize the present compositions. Exemplary organic solvents, include without limitation: alcohols including polyhydric alcohols; esters; ethers including glycol ethers; ketones; aldehydes; polar aprotic solvents such as dimethyl sulfoxide, tetramethylene sulfone (or sulfolane), and dimethyl sufur dioxide; aminoalcohols such as aminoethylaminoethanol; N-(C₁-C₁₀)alkylpyrrolidones such as N-methylpyrrolidone; amides such as dimethylacetamide and dimethylformamide; and amines. In one embodiment, the present compositions are free of polar aprotic solvents. In another embodiment, the present compositions are free of amide solvents.

Mixtures of organic solvents may be used. In one embodiment, the organic solvent is a mixture of an alcohol and an ether. More particularly, the organic solvent is a mixture of a polyhydric alcohol and an ether.

The polyhydric alcohols useful in the present invention are any which are miscible with water and do not destabilize the composition. The term "polyhydric alcohol" refers to an alcohol having 2 or more hydroxyl groups. Suitable polyhydric alcohols include aliphatic polyhydric alcohols such as (C₂-C₂₀)alkanediols, substituted (C₂-C₂₀)alkanediols, (C₂-C₂₀)alkanetriols, and substituted (C₂-C₂₀)alkanetriols. It will be appreciated by those skilled in the art that more than one polyhydric alcohol may be used in the present invention. Suitable aliphatic polyhydric alcohols include, but are not limited to, ethylene glycol, dihydroxypropanes such as 1,3-propanediol and propylene glycol, diethylene glycol, dipropylene glycol, triethylene glycol, tripropylene glycol, 2-methyl-1,3-propanediol, butanediol, pentanediol, hexanediol, and glycerol. In one embodiment, the polyhydric alcohol is chosen from 1,3-propanediol, propylene glycol, 2-methyl-1,3-propanediol, butanediol, and pentanediol. Polyhydric alcohols are generally commercially available, such as from Aldrich (Milwaukee, Wisconsin), and may be used without further purification.

The ethers useful in the present invention are any which are water miscible, compatible with the polyhydric alcohol and do not destabilize the composition. A wide variety of ether solvents may be used in the present compositions. Suitable ether solvents contain at least one ether linkage and may contain one or more other groups such as hydroxyl, amino, amido, keto, and halo. Suitable ethers include, without limitation, glycol mono(C₁-C₆)alkyl ethers and glycol di(C₁-C₆)alkyl ethers, such as (C₂-C₂₀)alkanediol (C₁-C₆)alkyl ethers and (C₂-C₂₀)alkanediol di(C₁-C₆)alkyl ethers. Exemplary ethers include, but are not limited to, ethylene glycol monomethyl ether, diethylene glycol monomethyl ether, propylene glycol monomethyl ether, propylene glycol dimethyl ether, propylene glycol mono-n-propyl ether, propylene glycol mono-n-butyl ether, dipropylene glycol monomethyl ether, dipropylene glycol dimethyl ether, dipropylene glycol mono-n-butyl ether, and tripropylene glycol monomethyl ether. In one embodiment, the ether is dipropylene glycol monomethyl ether or dipropylene glycol mono-n-butyl ether. Those skilled in the art will appreciate that mixtures of ethers may be used in the present invention. Suitable ether solvents are generally commercially available, such as from Aldrich, and may be used without further purification.

Typically, the organic solvent is present in an amount of 40 to 95 %wt, based on the total weight of the composition. In one embodiment, the organic solvent is present in an amount from 45 to 85 %wt, and more typically from 60 to 85 %wt. When a mixture of organic solvents is used, the weight ratio of the solvents may vary over a wide range. For example, the weight ratio of polyhydric alcohol to ether in the solvent mixture may vary such as from 1:8 to 8:1 and more typically from 1:4 to 4:1. Particularly useful weight ratios of polyhydric alcohol to ether are 2.5:1, 2:1, 1.5:1, 1:1, 1:1.5, and 1:2.

Any suitable type of water may be used in the present invention, such as deionized and distilled, with deionized water being typically used. Water is typically present in the composition in an amount from 5 to 50 %wt based on the total weight of the composition, although greater and lesser amounts may be used. More typically, water is present in an amount of 15 to 50 %wt based on the total weight of the composition, still more typically from 15 to 35 %wt, and even more typically from 15 to 30 %wt.

A wide variety of nitrogen-containing carboxylic acids may be used in the present compositions. Such nitrogen-containing carboxylic acids are soluble in alcohol and have a water solubility of ≥ 25 g per 100 g water at 25 °C. Typically, the nitrogen-containing carboxylic acids have a water solubility of ≥ 28 g, more typically ≥ 30 g, and still more typically ≥ 35 g, all per 100 g water at 25 °C. The nitrogen-containing carboxylic acids are also soluble in the present compositions (mixture of water and organic solvent) in amounts up to 1 %wt or greater, based on the total weight of water and organic solvent. Typically, the nitrogen-containing carboxylic acids are soluble in amounts up to 2 %wt or greater and more typically up to 5 %wt or greater, based on the total weight of water and organic solvent.

The nitrogen-containing carboxylic acids may contain one, two or more carboxylic acid groups. Such compounds may also contain one or more nitrogens and may optionally contain one or more other heteroatoms such as, but not limited to, sulfur and oxygen. In one embodiment, the nitrogen-containing carboxylic acids have a heterocyclic moiety. In another embodiment, the heterocyclic moiety is aromatic. Useful heterocyclic moieties typically have from 5 to 8 members in the ring and may contain 1 to 4 heteroatoms. Each such heteroatoms may be the same or different and may be chosen from nitrogen, oxygen, and sulfur, although other heteroatoms may be present. It is preferred that the nitrogen-containing carboxylic acids contain a heterocyclic moiety. Typically, the heterocyclic moiety is a nitrogen-containing ring, such as pyridine, piperidine, pyrrole, piperazine, and morpholine. The present nitrogen-containing carboxylic acids may optionally be substituted. By "substituted" it is meant that one or more hydrogens of the nitrogen-containing carboxylic acid are replaced by one or more substituent groups, such as, but not limited to, halo, alkyl, alkoxy, hydroxy, keto, amido, and amino.

Exemplary nitrogen-containing carboxylic acids useful in the present compositions include, without limitation, picolinic acid, pipecolinic acid, piperazine-2-carboxylic acid, 2,3-pyridinedicarboxylic acid, 2,6-pyridinedicarboxylic acid, nicotinic acid, isonicotinic acid, nipecotic acid and isonipecotic acid.

The nitrogen-containing carboxylic acids may be used in the present compositions in a wide range of amounts. The nitrogen-containing carboxylic acids are present in an amount of 0.001 %wt or greater based on the total weight of the composition. More typically, the nitrogen-containing carboxylic acids are used in amounts of 0.01 %wt or greater, still more typically 0.05 %wt or greater, and yet more typically 0.1 %wt or greater. In general, the nitrogen-containing carboxylic acids are present in the compositions in an amount up to 10 %wt, based on the total weight of the composition, although greater amounts may be used. More typically, the nitrogen-containing carboxylic acids are present up to 5 %wt, and still more typically up to 4 %wt. A particularly useful range of amounts of nitrogen-containing carboxylic acids is from 0.01 to 10 %wt and more particularly from 0.05 to 5 %wt.

The present compositions typically have a pH in the range of 3 to 8 based on a 5% solution of the composition in water, although higher and lower pH's may be used. In one embodiment, the pH is in the range of 4 to 8. In another embodiment, the pH is from 4 to 7. Optionally, the pH of the compositions may be adjusted as needed such as by the use of a pH adjuster. The choice of any such pH adjuster is well within the ability of those skilled in the art. In one embodiment, the pH adjuster is a carbonic acid or its salt, such as, but not limited to, ammonium carbonate. In another embodiment, the pH adjuster is a buffer.

Optional buffers include an acid and a base in a suitable molar ratio. In one embodiment the nitrogen-containing carboxylic acid may function as the acid in a buffer system. In another embodiment, the optional buffer system contains an acid different from the nitrogen-containing carboxylic acid. The acid in the buffer system may be inorganic or organic. Exemplary buffer systems include, without limitation, phosphate buffers and acetate buffers, such as ammonia/acetic acid (ammonium acetate). Various other buffering systems may be used. Such buffer systems are typically selected so that they will buffer the composition in the pH range of 3 to 8. In one embodiment, the acid of the buffer system is a polycarboxylic acid, such as , but not limited to, citric acid, isocitric acid, tartaric acid, oxalic acid, malonic acid, succinic acid, glutaric acid, adipic acid, maleic acid, fumaric acid, phthalic acid, L-glutamic acid, cis-aconitic acid, agaric acid, trans-aconitic acid, trimellitic acid, 4-(2-hydroxyethyl)piperazine-1-ethanesulfonic acid ("HEPES"), and trimesic acid. "Polycarboxylic acid" refers to any carboxylic acid having 2 or more carboxylic acid groups. In another embodiment, the base of the buffer system is an amine, such as, but not limited to, alkyldiamines, imines, cyclic amines and alkanolamines. Exemplary amines include, without limitation, 1,2-diaminopropane, morpholine, piperazine, imidazole, 1,2-dimethylimidazole, 1-methylimidazole, ethanolamine, diethanolamine, triethanolamine, triisopropanolamine, 1,8-diazabicyclo[5.4.0]undec-7-ene, 2,2-bis(hydroxymethyl)-2,2',2"-nitrilotriethanol ("bis-tris"), 3-(cyclohexylamino)-1-propanesulfonic acid, L-Histidine, 4-(N-morpholino)butanesulfonic acid, 4- morpholinepropanesulfonic acid, 3-morpholino-2-hydroxypropanesulfonic acid, N,N-dimethylethanolamine, N,N-dimethylisopropanolamine, N-methyldiethanolamine, N-methylethanolamine, diisopropanolamine, 1,2-propylenediamine, 1,3-diaminopropane, 2-(2-aminoethoxy)-ethanol, and 2-[2-(dimethylamino)ethoxy]ethanol. In such buffer systems, the molar ratio of the polycarboxylic acid to the base is typically 1:1 to 1:15.

The compositions of the present invention may optionally include one or more additives. Suitable optional additives include, but are not limited to, corrosion inhibitors, surfactants, chelating agents, and reducing agents.

Any suitable corrosion inhibitor may be used in the present compositions. The choice of such corrosion inhibitor will depend, in part, upon what needs to be protected from corrosion, e.g. specific metals or dielectrics. The selection of such corrosion inhibitors is within the ability of those skilled in the art. Exemplary corrosion inhibitors include, but are not limited to, hydroxybenzenes such as catechol, methylcatechol, ethylcatechol and tert-butylcatechol; benzotriazole; imidazole; benzimidazole; benzimidazolecarboxylic acid; imidazole-2-carboxylic acid; imidazole-4-carboxylic acid; imidazole-2-carboxaldehyde; imidazole-4-carboxaldehyde; 4-imidazoledithiocarboxylic acid; imidazo[1,2-a]pyridine; hydroxyanisole; gallic acid; gallic acid esters such as methyl gallate and propyl gallate; and tetra(C₁-C₄)alkylammonium silicates such as tetramethylammonium silicate. Such corrosion inhibitors are generally commercially available from a variety of sources, such as Aldrich and may be used without further purification. When such corrosion inhibitors are used in the present compositions, they are typically present in an amount of from 0.01 to 10 %wt, based on the total weight of the composition.

Nonionic, anionic and cationic surfactants may be used in the present compositions. Nonionic surfactants are preferred. Such surfactants are generally commercially available from a variety of sources. The surfactants are typically present in an amount of from 0 to 1 %wt, and more typically from 0.005 to 0.5 %wt, based on the total weight of the composition.

Any suitable chelating agent may be used in the present invention, such as ethylenediaminetetraacetic acid, and amino acids. Such chelating agents may be used in varying amounts, such as up to 10 %wt, based on the total weight of the composition, and more typically up to 5 %wt. the use of such chelating agents is within the ability of those skilled in the art.

A wide variety of reducing agents may be used in the present compositions. Exemplary reducing agents include, without limitation: reducing sugars such as sorbitol, arabitol, mannitol, sucrose, dextrose, maltose, and lactose; hydroquinones such as chlorohydroquinone, 2,3-dichlorohydroquinone, 2,5-dichlorohydroquinone, 2,6-dichlorohydroquinone, and methylhydroquinone; glyoxal; salicylaldehyde; ascorbic acid; nonanal; pyruvaldehyde; 2-methoxybenzaldehyde; vanillin; imidazole-2-carboxaldehyde; and imidazole-2-carboxaldehyde. Such reducing agents may be used in an amount from 0 to 15 %wt, based on the total weight of the composition. More typically, such reducing agents are present from 0.1 to 10 %wt, and still more typically from 0.5 to 5 %wt.

The compositions of the present invention may be prepared by combining the above components in any order. Preferably, the fluoride source is dissolved in the minimum amount of water required for dissolution of the fluoride source and then to the resulting solution is added the remainder of the components in any order.

The compositions of the present invention are suitable for removing post-plasma etch polymeric material from a substrate. Any polymeric material, such as, but not limited to, photoresists, soldermasks, antireflective coatings, underlayers and the like, that have been subjected to harsh process conditions such as plasma etching, auto-plasma ashing, ion implantation or ion milling processes, can be effectively removed from a substrate according to the present invention. Any polymeric material subjected to the harsh treatment processes described above is referred to as "post-plasma etch polymeric residue" throughout this specification. The compositions and methods of the present invention are particularly useful in removing the organometallic polymeric residue present after a dry plasma etching, reactive ion etching and ion milling of materials, such as photoresists, conducting metal layers and insulating dielectric layers.

Polymeric residue on a substrate may be removed by contacting the substrate with a composition of the present invention. The substrate may be contacted with the compositions of the present invention by any known means, such as immersion of the substrate in a bath, such as a wet chemical bench, containing a composition of the present invention such bath being at room temperature or heated, by spraying a composition of the present invention at a desired temperature on the surface of the substrate, or by depositing the composition onto the substrate in a single wafer cleaning tool. Following contact with the compositions of the present invention for a time sufficient to remove the polymeric residue, the substrate is typically rinsed such as with deionized water or iso-propanol, and is then dried such as by spin drying. When the compositions of the present invention are sprayed on a substrate, such spraying operation is typically performed in a spray chamber such as a solvent cleaning spray apparatus available from Semitool, Inc. (Kalispell, Montana). The time the substrate is in contact with a composition of the present invention will vary depending, in part, upon the concentration of fluoride ion in the composition, the amount of water in the composition, the temperature of the composition, and the type of polymeric residue being removed. Typical contact times range from 5 seconds to 60 minutes, although shorter or longer times may be used.

The polymeric residue removal process of the present invention may be carried out at a variety of temperatures, such as ambient temperature or at any other suitable temperature such as from 15 to 65 °C, preferably from 20 to 50 °C.

An advantage of the compositions of the present invention is that they may be effectively used to remove polymeric material from substrates including one or more dielectric layers without substantially etching the dielectric material. Typically, the compositions of the present invention etch dielectric materials at a rate of ≤ 50 Å/min, preferably at a rate of ≤ 20 Å/min, and more preferably at a rate of ≤ 10 Å/min, at 20 °C. Thus, the present compositions are compatible with a wide variety of dielectric materials, particularly low dielectric constant ("low-k") materials, such as, but not limited to, siloxanes, silicon dioxides, silsesquioxanes such as hydrogen silsesquioxane, methyl silsesquioxane, phenyl silsesquioxane and mixtures thereof, benzocyclobutenes, polyarylene ethers, polyaromatic hydrocarbons, and fluorinated silicon glasses.

Another advantage of the present compositions is their ability to remove copper oxide. The present compositions may remove copper oxide from a copper film at a rate of ≥ 15 Å/min., and more typically at a rate of≥ 20 Å/min.

The following examples are expected to illustrate various aspects of the invention.

### Example 1

The compositions in the following table were prepared by combining the components in the amounts listed in the following table. All amounts are reported in %wt.

| Sample | PDO | DPM | H₂O | AF | ABF | Picolinic Acid |
|---|---|---|---|---|---|---|
| 1 | 37.07 | 37.07 | 25.24 | 0.27 | 0.053 | 0.3 |
| 2 | 37.17 | 37.17 | 25.37 | 0.167 | 0.021 | 0.1 |

A copper film containing copper oxide was contacted with each of the above compositions. In each case, the copper oxide was removed.

### Example 2

Example 1 is repeated except that the components and amounts listed in the following table are used. These samples are expected to perform similarly to those in Example 1.

| Sample | PDO | DPM | H₂O | AF | ABF | Nitrogen-containing carboxylic acid (%wt) |
|---|---|---|---|---|---|---|
| 3 | 40.475 | 40.475 | 17 | 0.50 | 0.03 | Picolinic acid (1.52) |
| 4 | 29.275 | 29.275 | 40 | 0.50 | 0.05 | Pipecolinic acid (0.90) |
| 5 | 35.1 | 35.1 | 25 | 3.40 | 0 | 2,6-Pyridinedicarboxylic acid (1.40) |
| 6 | 35.0 | 35.0 | 25 | 3.40 | 0.01 | 2,3-Pyridinedicarboxylic acid (1.59) |
| 7 | 55.35 | 25.6 | 15 | 0.05 | 3.0 | Picolinic acid (1.00) |

### Example 3 (Comparative)

The formulation samples listed in the following table were prepared. The control formulation did not contain any nitrogen-containing carboxylic acid. Sample 8 contained picolinic acid. Samples C-1 to C-5 were comparative. Blanket wafer samples containing a 1000 Å physical vapor deposited copper layer were heated for 3 min. at 150 °C to form a copper oxide ("CuO") layer on the copper film. The CuO film thickness was determined using an ECI Technology QC-100 Sequential Electrochemical Reduction Analyzer operating at 90 microamps per square centimeter using a 0.16 cm diameter gasket. Each wafer sample was then contacted with one of the formulation samples in the table below for 30 seconds at room temperature (20-22 °C), rinsed with DI water and then dried using nitrogen. Following drying, the wafer samples were again analyzed to determine the CuO film thickness and the removal rates were then calculated.

| Sample | PDO | DPM | H₂O | AF | ABF | Nitrogen-containing carboxylic acid (%wt) | CuO Removal Rate (Å/min.) |
|---|---|---|---|---|---|---|---|
| Control | 39.83 | 39.83 | 20 | 0.30 | 0.05 | None | 0 |
| 8 | 39.63 | 39.63 | 20 | 0.30 | 0.05 | Picolinic acid (0.40) | 24 |
| C-1 | 39.70 | 39.70 | 20 | 0.30 | 0.05 | Glycine (0.25) | 14 |
| C-2 | 39.69 | 39.69 | 20 | 0 | 0.28 | Histidine (0.35) | 0 |
| C-3 | 39.60 | 39.60 | 20 | 0.36 | 0 | 2-Aminobenzoic acid (0.45) | 12 |
| C-4 | 39.62 | 39.62 | 20 | 0.36 | 0 | Iminodiacetic acid (0.40) | 12 |
| C-5 | 39.61 | 39.61 | 20 | 0.36 | 0 | 2-Thiophenecarboxylic acid (0.42) | 0 |

The above data clearly show that the compositions of the invention are very effective in removing copper oxide films.

### Example 4

Various amounts of nitrogen-containing carboxylic acids were evaluated to determine whether they were soluble using a solution of water (20 %wt), DPM (40 %wt) and PDO (40 %wt). These results were determined at 25 °C and are reported in the following table.

| Nitrogen-Containing Carboxylic Acid | %wt | Result |
|---|---|---|
| Picolinic acid | 5.0 | Soluble |
| 2-Aminobenzoic acid | 2.5 | Soluble |
| Glycine | 0.5 | Insoluble |
| Glycine | 0.4 | Soluble |
| Histidine | 0.4 | Insoluble |
| Histidine | 0.35 | Soluble |
| Iminodiacetic acid | 0.5 | Insoluble |
| Iminodiacetic acid | 0.4 | Soluble |

Picolinic acid, 2-aminobenzoic acid and glycine were also evaluated to determine their solubility in DI water at 25 °C. The results are shown in the following table in grams of compound per 100 grams of water. These compounds were also evaluated to determine whether they were soluble in an organic solvent (alcohol).

| Nitrogen-Containing Carboxylic Acid | Solubility (g/100g H₂O) | Solubility in Alcohol |
|---|---|---|
| Picolinic acid | 88.7 | Soluble |
| 2-Aminobenzoic acid | 0.6 | Soluble |
| Glycine | 25 | Slightly soluble |

### Example 5

Example 1 is repeated except that the components and amounts listed in the following table are used. These samples are expected to perform similarly to those in Example 1.

| Sample | Formulation |
|---|---|
| 9 | 36.5 % PG / 33 % PGP / 27.0 % H₂O / 0.5 % ABF / 0.5 % pipecolinic acid / 2.5 % glyoxal |
| 10 | 28.0 % PG / 27.0 % PGP and 10.0 % PGM/ 30.0 % H₂O /1.0 % ABF / 2.0 % 2,6-pyridinedicarboxylic acid / 2.0 % DBU |
| 11 | 33.7 % PG / 33.0 % PGP / 28.2 % H₂O / 3.02 % AF / 0.08 % ABF / 0.7 % picolinic acid / 1.3 % benzotriazole |
| 12 | 33.4% PDO/31.0%PGP and 10.0% PGM/18.6% H₂O/3.0% TMAF/ 2.0 % piperazine-2-carboxylic acid / 2.0 % nonanal |
| 13 | 29.75 % PG / 35.0 % DPM / 28.0 % H₂O / 1.0 % TMAF / 1.0 % citric acid / 4.0 % TEOA / 0.25 % picolinic acid / 1.0 % benzotriazole |
| 14 | 44.0 % PG / 26.5 % PGP / 25.0 % H₂O / 2.0 % ABF / 2.5 % piperazine-2-carboxylic acid |
| 15 | 38.0 % PG / 25.0 % PGP / 25.0 % H₂O / 2.0 % ABF / 10 % picolinic acid |

## Claims

1. A composition for the removal of polymeric material from a substrate comprising: (a) 0.05 to 5 %wt of a fluoride source; (b) 40 to 95 %wt of organic solvent; (c) 5 to 50 %wt water; and (d) a nitrogen-containing carboxylic acid that is soluble in alcohol and has a water solubility of ≥ 25 g per 100 g water at 25 °C.

2. The composition of claim 1 wherein the fluoride source is chosen from ammonium fluoride, ammonium bifluoride, tetraalkylammonium fluoride, ammonium-tetraalkylammonium bifluoride, and mixtures thereof.

3. The composition of claim 1 wherein the organic solvent comprises a mixture of a polyhydric alcohol and an ether.

4. The composition of claim 1 wherein the nitrogen-containing carboxylic acid has a heterocyclic moiety.

5. The composition of claim 4 wherein the heterocyclic moiety is aromatic.

6. The composition of claim 1 further comprising a base.

7. The composition of claim 6 wherein the base is an amine.

8. The composition of claim 1 wherein the pH is from 3 to 8.

9. The composition of claim 1 further comprising an additive chosen from corrosion inhibitors, surfactants, co-solvents, chelating agents, reducing agents and mixtures thereof.

10. A method of removing polymeric residue from a substrate comprising the step of contacting a substrate comprising polymeric residue with the composition of claim 1 for a period of time sufficient to remove the polymeric residue.
